# EUROPÄISCHE PATENTSCHRIFT

(11) **EP 2 582 049 B1**
(45) Veröffentlichungstag und Bekanntmachung des Hinweises auf die Patenterteilung: **20.04.2016**
(21) Anmeldenummer: 11008228.6
(22) Anmeldetag: 12.10.2011
(51) Int. Cl.: H03M 1/10, H03M 1/20, H03M 1/08, G01D 3/02

(54) **Verfahren zum digitalen Verarbeiten eines analogen Messignals und Vorrichtung zur Durchführung des Verfahrens**
Method for digitally processing an analogue measurement signal and device for executing the method
Procédé de traitement numérique d'un signal de mesure analogique et dispositif d'exécution du procédé

(43) Veröffentlichungstag der Anmeldung: 17.04.2013
(73) Patentinhaber: Balluff GmbH, 73765 Neuhausen a.d.F. (DE)
(72) Erfinder: Kántor, Zoltán, 8248 Nemesvámos (HU)
(74) Vertreter: Jakelski & Althoff Patentanwälte PartG mbB

(56) Entgegenhaltungen:
- US-A1- 2004 177 102
- ATTIVISSIMO ET AL: "Effects of midpoint linearization and nonsubtractive dithering in A/D converters", MEASUREMENT, Bd. 40, Nr. 5, 31. Mai 2007 (2007-05-31), Seiten 537-544, XP022099439, INSTITUTE OF MEASUREMENT AND CONTROL. LONDON, GB ISSN: 0263-2241, DOI: 10.1016/J.MEASUREMENT.2006.08.007
- HOLUB J ET AL: "Various scale errors in dithered quantizers - Visualisation and reduction", MEASUREMENT, Bd. 28, Nr. 2, 1. September 2000 (2000-09-01), Seiten 85-91, XP004201650, INSTITUTE OF MEASUREMENT AND CONTROL. LONDON, GB ISSN: 0263-2241, DOI: 10.1016/S0263-2241(99)00035-4
- Holub, J et al: "LARGE SCALE ERROR REDUCTION IN DITHERED ADC", BME MIT IMEKO 2000 5th Workshop on ADC Modeling and Testing, 25. September 2000 (2000-09-25), 28. September 2000 (2000-09-28), Seiten 1-6, XP002671022, Vienna Gefunden im Internet: URL:http://home.mit.bme.hu/~kollar/IMEKO-p rocfiles-for-web/congresses/WC-16th-Wien-2 000/Papers/Topic%20ADC/Holub.PDF [gefunden am 2012-03-07]

## Beschreibung

Die Erfindung geht aus von einem Verfahren zum digitalen Verarbeiten eines analogen Messsignals und von einer Vorrichtung zur Durchführung des Verfahrens nach der Gattung der unabhängigen Ansprüche.

### Stand der Technik

Zur Aufbereitung eines analogen Messsignals wird das von einem Sensor bereitgestellte analoge Messsignal einem Analog/Digital-Wandler zugeführt, der ein der geforderten Auflösung entsprechend hohes Auflösungsvermögen aufweisen muss. Das Auflösungsvermögen wird durch die Anzahl der Quantisierungsstufen, beispielsweise 16 Bit festgelegt. Nach der Digitalisierung des analogen Messwerts ist im Allgemeinen eine Linearisierung oder sonstige Signalkorrektur vorgesehen, wobei die Linearisierung durch eine analytische Umkehrfunktion der Sensorkennlinie oder mithilfe einer Tabelle und einer anschließenden Interpolation erfolgt.

Hochauflösende Analog/Digital-Wandler sind vergleichsweise teure Bauelemente, welche die Kostenbilanz einer Vorrichtung zur Messsignal-Aufbereitung negativ beeinflussen. Die beschriebene digitale Signalverarbeitung erfordert zahlreiche arithmetische Operationen, wodurch ein hoher Programmieraufwand entsteht, der die Kosten weiter erhöht.

Falls der zur Erfassung des analogen Messsignals eingesetzte Sensor eine Querempfindlichkeit beispielsweise gegenuber der Temperatur aufweist, kann eine Korrektur der Querempfindlichkeit erforderlich werden. Zur Aufrechterhaltung der gegebenenfalls geforderten hohen Auflösung des analogen Messsignals muss das Korrektur-Messsignal gleichermaßen mit einem hoch auflösendem Analog/DigitalWandler in ein digitales Messsignal umgesetzt werden.

Eine Verbesserung der Ausnutzung eines niedrig auflösenden Analog/DigitalWandlers ist durch den Einsatz eines Dithersignals möglich, welches dem analogen Messsignal überlagert wird. Das Dithersignal soll zu einer Erhöhung des Rauschanteils des analogen Messsignals mit dem Ziel führen, wenigstens zwei, vorzugsweise mehrere Quantisierungsstufen des niedrig auflösenden Analog/Digital-Wandlers zu nutzen, obwohl das analoge Messsignal beispielsweise zwischen zwei Quantisierungsstufen des Analog/Digital-Wandlers liegt. Ohne Dithersignals würde am Digitalausgang des Analog/Digital-Wandlers stets der gleiche digitale Wert bereitgestellt, beispielsweise ein Wert, welcher der nächstgelegenen niedrigeren Quantisierungsstufe entspricht. Mittels des Dithersignals können daher die einzelnen Quantisierungsstufen des Analog/Digital-Wandlers besser ausgenutzt werden, wodurch sich eine höhere Auflösung des analogen Messsignals erzielen lässt Der durch das Dithersignal bedingte zusätzliche Rauschanteil kann durch eine Tiefpassfilterung des verarbeiteten Signals vermindert werden.

Eine solche Vorgehensweise ist beispielsweise in der US-Patentschrift 7 233 746 B2 beschrieben. In diesem Dokument ist ein Verfahren zur Aufbereitung eines analogen Messsignals beschrieben, das einen großen Dynamikbereich aufweist. Die Vorgehensweise ist im Rahmen einer Strommessung an einem elektrischen Leiter mittels eines optischen Sensors beschrieben.

Der hohe Dynamikbereich wird mit einem Dithersignal erreicht, das vor der Analog/Digital-Wandlung dem analogen Messsignal überlagert wird. Das aus dem analogen Messsignal und dem Dithersignal resultierende Überlagerungssignal wird nach der Analog/Digital-Wandlung einem digitalen Signalprozessor zugeführt. Der digitale Signalprozessor verarbeitet das digitalisierte Überlagerungssignal mit verschiedenen Rechenschritten, um das analoge Messsignal als korrektes Messsignal oder zumindest einen Parameter des Messsignals zu erhalten. Zusätzlich zur Erfassung des vom Stromsensor bereitgestellten analogen Messsignals ist die Erfassung der am elektrischen Leiter anliegenden Spannung vorgesehen, die von einem weiteren Analog/Digital-Wandler in ein digitales Spannungs-Messsignal umgesetzt, wobei in diesem Signalzweig der Einsatz eines weiteren Dithersignals nicht vorgesehen ist, Das digitalisierte Spannungs-Messsignal kann im digitalen Signalprozessor zur Berechnung der elektrischen Momentanleistung herangezogen werden.

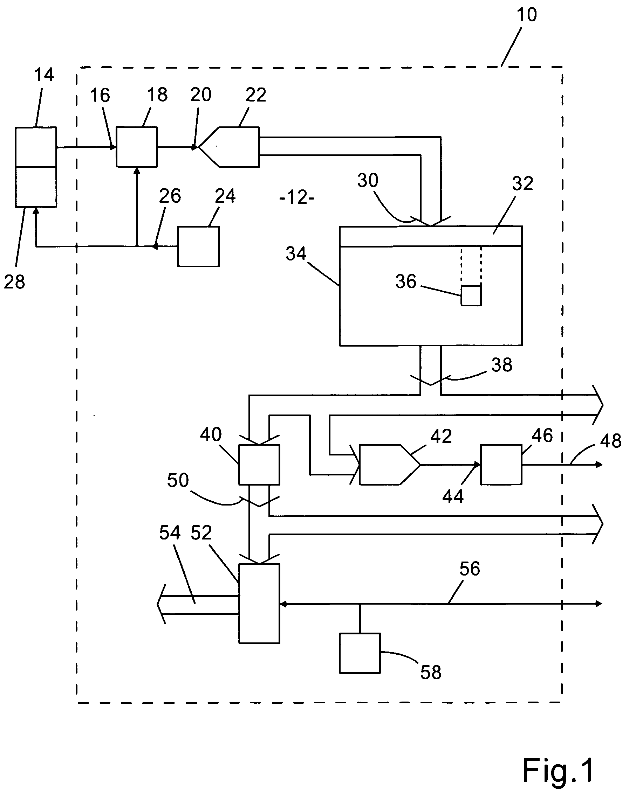

In dem Fachzeitschriftenbeitrag "Effects of midpoint linearization and nonsubtractive dithering in A/D converters", Attivissimo et al, Measurement, Bd. 40, Nr. 5, 31. Mai 2007, Seiten 537-544, Institute of Measurement and Control. London, GB, ISSN: 0263-2241, DOI: 10.1016/ J. Measurement 07.08.2006, Seiten 537-541, Abbildung 1" ist ein Verfahren zur Umwandlung wenigstens eines von wenigstens einem Sensor bereitgestellten analogen Messsignals zu einem gemittelten korrekten Messsignal beschrieben, wobei dem vom Sensor bereitgestellten analogen Messsignal ein Dithersignal überlagert wird, das entstehende Messsignal-Überlagerungssignal anschließend analog/digitalgewandelt wird und das digitalisierte Messkanal-Überlagerungssignal unmittelbar eine Tabelle adressiert und wobei die adressierten einzelnen korrekten Messwerte aus der Tabelle ausgelesen und als digitales korrektes Messsignal bereitgestellt werden, das digitale korrekte Messsignal mittels einer digitalen Tiefpassfilterung gefiltert und als digitales gemitteltes korrektes Messsignal bereitgestellt wird. Das bekannte Verfahren sieht eine Linearisierung des vom Sensor bereitgestellten analogen Messsignals vor, wobei die in der Tabelle hinterlegten korrekten Messwerte jeweils dem gewünschten linearisierten Messwert entsprechen.

Der Erfindung liegt die Aufgabe zugrunde, ein Verfahren zur digitalen Verarbeitung wenigstens eines von wenigstens einem Sensor bereitgestellten analogen Messsignals sowie eine Vorrichtung zur Durchführung des Verfahrens anzugeben, die sowohl eine hohe Auflösung des wenigstens einen analogen Messsignals mit einem vergleichsweise niedrig auflösenden Analog/Digital-Wandler als auch eine Korrektur ermöglichen und die mit einer besonders einfachen digitalen Signalverarbeitung realisiert werden können.

Die Aufgabe wird durch die in den unabhängigen Ansprüchen angegebenen Merkmale jeweils gelöst.

### Offenbarung der Erfindung

Das erfindungsgemäße Verfahren zur Umwandlung wenigstens eines von wenigstens einem Messkanal-Sensor bereitgestellten analogen Messsignals zu einem analogen gemittelten korrekten Messsignal, geht davon aus, dass dem vom Messkanal-Sensor bereitgestellten analogen Messsignal ein Messkanal-Dithersignal überlagert wird, das entstehende Messkanal-Überlagerungssignal anschließend analog/digital-gewandelt wird und das digitalisierte Messkanal-Überlagerungssignal unmittelbar eine Tabelle adressiert, wobei in der Tabelle eine Kalibrierfunktion des Messkanal-Sensors als zu den ganzzahligen Werten des digitalisierten analogen Messsignals gehörende korrekte Messwerte hinterlegt ist, das digitalisierte Messkanal-Überlagerungssignal unmittelbar die Tabelle adressiert und die adressierten einzelnen korrekten Messwerte aus der Tabelle ausgelesen und als digitales korrektes Messsignal bereitgestellt werden. Das erfindungsgemäße Verfahren zeichnet sich dadurch aus, dass zur Korrektur einer Querempfindlichkeit gegenüber einer anderen Größe als die Messgröße des vom Messkanal-Sensor bereitgestellten analogen Messsignals weiterhin ein von wenigstens einem Korrekturkanal-Sensor, der die andere Größe misst, erfasstes analoges Korrektursignal mit einem Korrekturkanal-Dithersignal überlagert und das entstehende Korrekturkanal-Überlagerungssignal anschließend analog/digitalgewandelt wird, dass die Tabelle als wenigstens zweidimensionale Tabelle ausgebildet ist, dass in der Tabelle eine zweidimensionale Kalibrierfunktion hinterlegt ist, dass das digitalisierte Korrekturkanal-Überlagerungssignal die Tabelle ebenfalls unmittelbar adressiert, dass die jeweils vom digitalisierten Messkanal-Überlagerungssignal und dem digitalisierten Korrekturkanal-Überlagerungssignal adressierten, korrekten Messwerte als das digitale korrekte Messsignal aus der Tabelle ausgelesen und als das digitale korrekte Messsignal bereitgestellt werden, das digitale korrekte Messsignal durch einen Digital/Analog-Wandler digital/analog-gewandelt wird, das durch den Digital/Analog-Wandler bereitgestellte analoge korrekte Messsignal mittels des analogen Tiefpassfilters gefiltert und als das analoge gemittelte korrekte und gegenüber der Querempfindlichkeit kompensierte Messsignal bereitgestellt wird.

Ein erster Vorteil der erfindungsgemäßen Vorgehensweise ergibt sich durch den Einsatz des Dithersignals, wodurch das Auflösungsvermögen eines vergleichsweise niedrig auflösenden Analog/Digital-Wandlers besser genutzt wird. Besonders vorteilhaft ist sehr einfache Gewinnung des digitalen korrekten Messwerts dadurch, dass das digitalisierte Messkanal-Überlagerungssignal unmittelbar zur Adressierung einer Tabelle herangezogen wird, in welcher die digitalen korrekten Messwerte hinterlegt sind. Die Bereitstellung eines digitalen korrekten Messsignals wird dadurch ohne Rechenoperationen erreicht, sodass ein bisher erforderlicher Hardware- und Programmieraufwand entfallen.

Die Tabelle mit den digitalen korrekten Messwerten kann beispielsweise am Ende des Produktionsprozesses beim Hersteller der Vorrichtung im Rahmen eines Kalibriervorgangs erstellt werden. Weiterhin kann die Tabelle von einem Kunden erstellt werden. Darüber hinaus kann die Tabelle von Zeit zu Zeit während des Einsatzes der erfindungsgemäßen Vorrichtung neu erstellt werden, um beispielsweise einer Langzeitdrift des Messkanal-Sensors begegnen zu können. Neben den Kostenvorteilen durch die Einsatzmöglichkeit von preiswerten Analog/Digital-Wandlern mit einer im Vergleich zur geforderten Auflösung des Messsignals geringen Auflösung beziehungsweise wenigen Quantisierungsstufen, ergibt sich durch den Entfall einer aufwendigen Signalverarbeitung ein weiterer Kostenvorteil.

Aufgrund der verringerten Auflösung des Analog/Digital-Wandlers und dem entsprechend geringen Adressraum muss die Tabelle vergleichsweise wenige Speicherplätze zur Verfügung stellen. Beispielsweise werden bei einem 8-Bit Analog/Digital-Wandler nur 256 Speicherplätze benötigt. Bei hinterlegten Daten mit einer Breite von 8 Bit sind nur 256 kByte erforderlich, die beispielsweise ein Flash-Speicher oder ein EEPROM eines Mikrocontrollers bereitstellen kann.

Die vergleichsweise einfache Realisierung mittels weniger Komponenten ermöglicht eine kostengünstige und flexible Fertigung, die insbesondere bei der Serienproduktion Kostenvorteil bietet. Durch die einfache Realisierung wird eine flexible Fertigung erreicht, die schnell auf vorgegebene Änderungen von Messbereichen oder Auflösungsvermögen reagieren kann. Kundenspezifische Vorgaben können schnell und kostengünstig berücksichtigt werden.

Weiterhin wird durch den einfachen Aufbau mit wenigen Komponenten eine hohe Sicherheit gegenüber Störsignalen erreicht, die bei dem Einsatz des Messkanal-Sensors in rauen Umgebungsbedingungen auftreten können, beispielsweise verursacht durch starke elektromagnetische Störimpulse von Fertigungsanlagen.

Durch die erfindungsgemäße Vorgehensweise, gemäß der das von wenigstens einem Korrekturkanal-Sensor erfasste analoge Korrektursignal mit einem Korrekturkanal-Dithersignal überlagert und das Korrekturkanal-Überlagerungssignal anschließend analog/digital-gewandelt wird, dass die Tabelle wenigstens als zweidimensionale Tabelle ausgebildet ist, dass das digitalisierte Korrekturkanal-Überlagerungssignal die Tabelle ebenfalls unmittelbar adressiert und dass die jeweils von dem digitalisierten Messkanal-Überlagerungssignal und dem digitalisierten Korrekturkanal-Überlagerungssignal adressierten korrekten Messwerte von der Tabelle als digitales korrektes Messsignal bereitgestellt werden und ausgelesen werden können, ergibt sich der besondere Vorteil dass gleichzeitig neben der Korrektur einer Kennlinie des vom Messkanal-Sensor bereitgestellten analogen Messsignals auch eine Korrektur von wenigstens einer Umgebungsgröße des Umfelds, in welchem sowohl der Messkanal-Sensor als auch der Korrektursignal-Sensor angeordnet ist, auf dieselbe vorteilhafte signaltechnische Weise.

Vorgesehen ist eine Signalverarbeitung des aus der Tabelle ausgelesenen digitalen korrekten Messsignals mittels einer digitalen beziehungsweise, nach einer Digital/Analog-Umsetzung des digitalen korrekten Messwerts mittels einer analogen Tiefpassfilterung. Der Frequenzgang des digitalen Tiefpassfilters ist an das gewünschte zeitliche Auflösungsvermögen des analogen Messsignals anzupassen. Die Tiefpassfilterung entspricht einer Mittelwertbildung, welche dem durch das Dithersignal verursachten höheren Rauschanteil entgegen wirkt. Weiterhin führt die vergleichsweise einfache Mittelwertbildung zu einer Interpolation, sodass ein korrektes Messsignal bereitgestellt werden kann, das auch Werte aufweisen kann, die zwischen Quantisierungsstufen des Analog/Digital-Wandlers liegen.

Mit den vorgesehenen Maßnahmen werden eine besonders einfache Erfassung des von wenigstens einem Messkanal-Sensor bereitgestellten analogen Messsignals sowie eine Korrektur wenigstens einer Querempfindlichkeit des vom Messkanal-Sensor bereitgestellten analogen Messsignals möglich. Sowohl das analoge Messsignal als auch das analoge Korrektursignal können durch die Überlagerung jeweils mit einem Dithersignal mit einem vergleichsweise niedrig auflösenden Analog/Digital-Wandler dennoch hoch aufgelöst erfasst werden. Die unmittelbare Adressierung der wenigstens zweidimensionalen Tabelle einerseits durch das digitalisierte Messkanal-Überlagerungssignal und andererseits durch das digitalisierten Korrekturkanal-Überlagerungssignal zur Auswahl der in der Tabelle hinterlegten korrekten Messwerte zum Bereitstellen eines digitalen korrekten Messsignals ist mit einfachsten Maßnahmen ohne den Einsatz von Rechenschritten möglich.

Vorteilhafte Weiterbildungen und Ausgestaltungen der erfindungsgemäßen Vorgehensweise sind jeweils Gegenstände der abhängigen Ansprüche.

Vorzugsweise ist eine Korrektur einer Querempfindlichkeit des Messkanal-Sensors gegenüber der Temperatur vorgesehen, sodass die Temperaturabhängigkeit des analogen Messsignals mit einfachsten Mitteln korrigiert werden kann.

Eine Ausgestaltung sieht die Überlagerung der von den Sensoren bereitgestellten analogen Signale mit dem Dithersignal im Rahmen einer Signaladdition vor Alternativ kann das Dithersignal den analogen Signalen auch dadurch überlagert werden, dass jeweils Stromversorgungen der Sensoren mit den Dithersignalen moduliert werden. Dadurch kann der Addierer entfallen.

Ausgestaltungen betreffen die Bereitstellung der Dithersignale. Das Messkanal-Dithersignal wie auch das Korrekturkanal-Dithersignal können mittels einer Binär-Zufallszahlenfolge erzeugt werden, welche eine vorzugsweise als Mikrocontroller realisierte signalverarbeitende Anordnung an einem Digitalausgang bereitstellt. Alternativ können das Messkanal-Dithersignal beziehungsweise das Korrekturkanal-Dithersignal mittels der niedrigwertigsten Bits der Analog/DigitalWandlung des Messkanal-Überlagerungssignals oder des Korrekturkanal-Überlagerungssignals bereitgestellt werden.

Eine vorteilhafte Ausgestaltung sieht vor, dass die Speicherplätze in der Tabelle zur Hinterlegung vorgesehenen korrekten Messwerte beispielsweise im Rahmen eines Kalibriervorgangs vom Messkanal beziehungsweise vom Korrekturkanal adressiert werden und dass in den vom Messkanal-Überlagerungssignal beziehungsweise vom Korrekturkanal-Überlagerungssignal adressierten Speicherplätzen die extern zur Verfügung gestellten korrekten Messwerte hinterlegt werde. Hierbei sind das Messkanal-Dithersignal und das gegebenenfalls vorhandene Korrekturkanal-Dithersignal abzuschalten, sodass das Messkanal-Überlagerungssignal identisch mit dem analogen Messsignal und das Korrekturkanal-Überlagerungssignal identisch mit dem analogen Korrektursignal werden.

Die erfindungsgemäße Vorrichtung zur Durchführung des Verfahrens sieht einen Messkanal-Dithersignalgenerator zum Bereitstellen eines Dithersignals zur Überlagerung mit dem analogen Messsignal, einen Messkanal Analog/Digital-Wandler zur Digitalisierung des Messkanal-Überlagerungssignals sowie eine Tabelle vor. Weiterhin sieht die erfindungsgemäße Vorrichtung zur Durchführung des Verfahrens den Einsatz eines Korrekturkanal-Dithersignalgenerators zur Überlagerung des von einem Korrekturkanal-Sensor bereitgestellten analogen Korrektursignals, ein Korrekturkanal-Analog/Digital-Wandler zur Digitalisierung des Korrekturkanal-Überlagerungssignals und insbesondere eine zweidimensionale Tabelle, wobei das digitalisierte Messkanal-Überlagerungssignal sowie das digitalisierte Korrekturkanal-Überlagerungssignal unmittelbar die in der Tabelle hinterlegten korrekten Messwerte adressieren, die dann die Tabelle als digitales korrektes Messsignal bereitstellt, welches durch die Auslesung der digitalen korrekten Messwerte aus der Tabelle gegeben ist. Weiterhin sieht die erfindungsgemäße Vorrichtung zur Durchführung des Verfahrens entweder einen Digital/Analog-Wandler zur Bereitstellung des analogen korrekten Messsignal sowie ein analoges Tiefpassfilter vor, welches das analoge gemittelte korrekte Messsignal bereitstellt, oder ein digitales Tiefpassfilter vor, welches das digitale gemittelte korrekte Messsignal bereitstellt.

Eine Ausgestaltung der Vorrichtung sieht eine digitale Schnittstelle vor. Die digitale Schnittstelle ermöglicht beispielsweise eine Hinterlegung von korrekten Messwerten in der Tabelle auch nach Herstellung und Bandende-Programmierung während des späteren Einsatzes der erfindungsgemäßen Vorrichtung. An der digitalen Schnittstelle kann insbesondere eine externe Signalleitung angeschlossen sein, die in bevorzugter Weise im Rahmen einer asynchronen seriellen Kommunikation im Duplexbetrieb betrieben wird.

Bevorzugt wird die externe Signalleitung gleichzeitig als Stromversorgungsleitung der signalverarbeitenden Anordnung benutzt. Das zu übertragende Signal kann in diesem Fall der Versorgungsspannung überlagert werden.

Eine Kommunikation, bei welcher eine analoge Ausgangsleitung und die externe Signalleitung eingesetzt sind, ermöglicht die Verwendung von vorhandenen 3-Leitungs-Sensoren.

Als Sensor zur Bereitstellung des analogen Messsignals kann bevorzugt ein induktiver oder kapazitiver Abstandssensor vorgesehen sein. Solche Sensoren werden von der Anmelderin unter der Internetadresse www.balluff.com angeboten Derartige Sensoren werden insbesondere in industriellen Umgebungen eingesetzt, wo mit dem Auftreten starker elektromagnetischer Störungen gerechnet werden muss. Hier macht sich die geringe Störempfindlichkeit, welche mit der erfindungsgemäßen Vorgehensweise erreicht wird, besonders vorteilhaft bemerkbar.

Ausführungsbeispiele der Erfindung sind in der Zeichnung dargestellt und in der nachfolgenden Beschreibung näher erläutert.

### Kurzbeschreibung der Figuren

Figur 1 zeigt ein technisches Umfeld, in welchem ein erfindungsgemäßes Verfahren abläuft,
Figur 2 zeigt einen funktionalen Zusammenhang zwischen einer Adresse und den in einer Tabelle hinterlegten adressierten korrekten Messwerten,
Figur 3 zeigt ein weiteres technisches Umfeld, in welchem ein erfindungsgemäßes Verfahren abläuft und
Figur 4 zeigt einen funktionalen Zusammenhang zwischen zwei unterschiedlichen Adressen und den in einer mindestens zweidimensionalen Tabelle hinterlegten adressierten korrekten Messwerten.

Figur 1 zeigt eine signalverarbeitende Anordnung 10, die einen Messkanal 12 aufweist, an welchem ein Messkanal-Sensor 14 angeschlossen werden kann. Der Messkanal-Sensor 14 stellt ein analoges Messsignal 16 bereit, welches einer Messkanal-Überlagerungsvorrichtung 18 zugeführt ist, die ein Messkanal-Überlagerungssignal 20 einem Messkanal-Analog/Digital-Wandler 22 zur Verfügung stellt.

Der Messkanal 12 enthält weiterhin einen Messkanal-Dithersignalgenerator 24, der ein Messkanal-Dithersignal 26 bereitstellt, welches der Messkanal-Überlagerungsvorrichtung 18 oder einer Messkanal-Sensor-Stromversorgung 28 zur Verfügung gestellt wird.

Der Messkanal-Analog/Digital-Wandler 22 gibt ein digitalisiertes Messkanal-Überlagerungssignal 30 aus, welches einem ersten Adressiereingang 32 einer Tabelle 34 zugeführt wird. Die Tabelle 34 enthält korrekte Messwerte 36, die als digitales korrektes Messsignal 38 aus der Tabelle 34 ausgelesen werden.

Das digitale korrekte Messsignal 38 wird sowohl einem digitalen Tiefpassfilter 40 als auch einem Digital/Analog-Wandler 42 zur Verfügung gestellt und kann weiterhin von der signalverarbeitenden Anordnung 10 direkt ausgegeben werden.

Das vom Digital/Analog-Wandler 42 bereitgestellte analoge korrekte Messsignal 44 wird einem analogen Tiefpassfilter 46 zur Verfügung gestellt, welches ein analoges gemitteltes korrektes Messsignal an einer analogen Ausgangsleitung 48 der signalverarbeitenden Anordnung 10 zur Verfügung stellt.

Ein digitales gemitteltes korrektes Messsignal 50, welches das digitale Tiefpassfilter 40 bereitgestellt, wird von der signalverarbeitenden Anordnung 10 ausgegeben und einer Schnittstelle 52 zur Verfügung gestellt. Die Schnittstelle 52 ist weiterhin mit einem internen Datenbus 54 und mit einer externen Signalleitung 56 verbunden, wobei die externe Signalleitung 56 an einen Ausgang der signalverarbeitenden Anordnung 10 geführt ist. Die externe Signalleitung 56 ist mit einer Stromversorgung 58 der signalverarbeitenden Anordnung 10 verbunden.

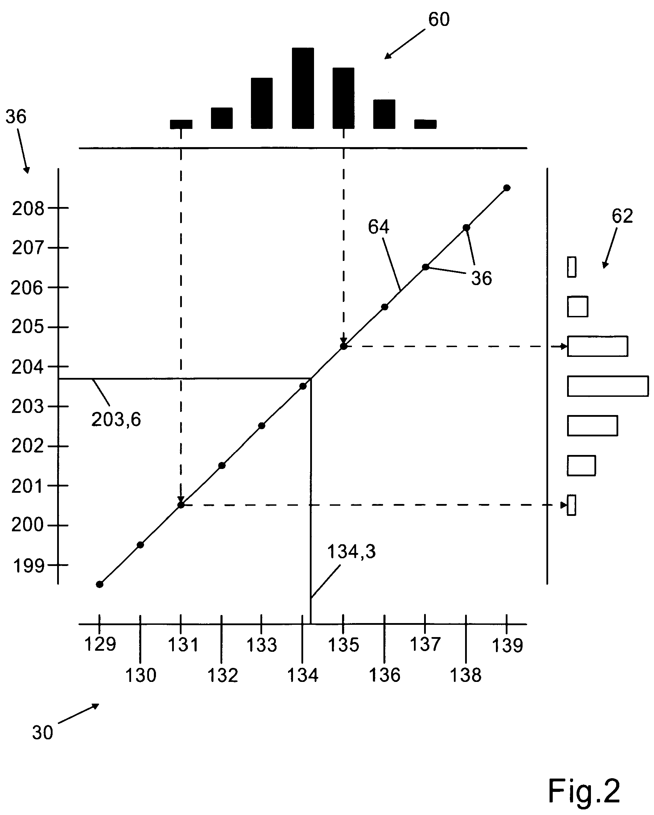

Das erfindungsgemäße Verfahren zum digitalen Verarbeiten wenigstens eines analogen Messsignals 16 wird anhand der in Figur 1 beschriebenen Vorrichtung und anhand des in Figur 2 gezeigten funktionalen Zusammenhangs zwischen den vom digitalisierten Messkanal-Überlagerungsignal 30 am ersten Adressiereingang 32 der Tabelle 34 anliegenden Adressen und den in der Tabelle 34 hinterlegten korrekten Messwerten 36 näher erläutert:

Der Messkanal-Sensor 14, beispielsweise ein bereits eingangs erwähnter induktiver oder kapazitiver Abstandssensor der Anmelderin, stellt das hoch aufgelöste analoge Messsignal 16 bereit, das einer digitalen Auflösung von beispielsweise 12 bis 16 Bit entspricht. Eine unmittelbare Konvertierung eines derart hoch aufgelösten analogen Messsignals 16 in ein Digitalsignal würde Analog/Digital-Wandler mit einer entsprechend hohen Auflösung erfordern. Aus Kostengründen soll jedoch ein niedriger auflösender Messkanal-Analog/Digital-Wandler 22 eingesetzt werden, der erheblich preiswerter erhältlich ist.

Eine höhere Auflösung kann auch mit einem niedrig auflösenden Analog/DigitalWandler erreicht werden, wenn dem analogen Messsignal 16 das Messkanal-Dithersignal 26 überlagert wird, welches der Messkanal-Dithersignalgenerator 24 bereitstellt. Das Messkanal-Dithersignal 26 kann beispielsweise weißes Rauschen sein, dessen obere Grenzfrequenz weit oberhalb der des analogen Messsignals 16 liegt. Die mittlere Frequenz des Messkanal-Dithersignals liegt beispielsweise 10-fach höher als die des analogen Messsignals 16.

Das Messkanal-Dithersignal 26 kann in der Messkanal-Überlagerungsvorrichtung 18 dem analogen Messsignal 16 überlagert werden. Die Messkanal-Überlagerungsvorrichtung 18 ist beispielsweise ein Addierer. Alternativ kann das Messkanal-Dithersignal 26 einer Messkanal-Sensor-Stromversorgung 28 zugeführt werden, sofern beispielsweise die Versorgungsspannung unmittelbar einen Einfluss auf das analoge Messsignal 16 aufweist, sodass mit dem Messkanal-Dithersignal 26 das analoge Messsignal 16 gewissermaßen moduliert wird.

Die mittlere Amplitude des Messkanal-Dithersignals 26 sollte in Bezug auf den Abstand der Quantisierungsstufen des Messkanal-Analog/Digital-Wandlers 22 derart festgelegt sein, dass bei einem gleichbleibenden, zwischen zwei Quantisierungsstufen liegenden analogen Messsignal 16 der Messkanal-Analog/DigitalWandler 22 zwischen zwei Quantisierungsstufen ständig wechseln kann. Vorzugsweise können mehrere Quantisierungsstufen abgedeckt werden.

In Figur 2 ist waagrecht das digitalisierte Messkanal-Überlagerungssignal 30 aufgetragen, das im gezeigten Ausführungsbeispiel den digitalen Werten von 129 bis 139 entsprechen soll. Aufgrund der Überlagerung mit dem Messkanal-Dithersignal 26 entsteht eine Häufigkeitsverteilung des digitalisierten Messkanal-Überlagerungssignals 30 um das tatsächliche analoge Messsignal 16, wobei das tatsächliche analoge Messsignal 16 im gezeigten Ausführungsbeispiel bei 134,3 liegen soll.

Unter der Voraussetzung, dass eine Überabtastung vorgesehen ist, bei welcher der Messkanal-Analog/Digital-Wandler 22 eine höhere Abtastrate, beispielsweise eine 10-fach höhere Abtastrate aufweist, als es das Nyquist-Kriterium vorschreibt, kann aus der Häufigkeitsverteilung 60 mit einer späteren Mittelwertbildung das analoge Messsignal 16 vergleichsweise genau rekonstruiert werden. Im gezeigten Ausführungsbeispiel liegt die Häufigkeitsverteilung 60 zwischen den Werten 131 bis 137 des digitalisierten Messkanal-Überlagerungssignals 30.

Mit den konkreten Werten zwischen 131 und 137 werden die einzelnen in der Tabelle 34 hinterlegten korrekten Werte 36 adressiert, die in vertikaler Richtung aufgetragen sind, wobei die korrekten Messwerte 36 im gezeigten Ausführungsbeispiel zwischen 199 und 208 eingetragen sind, wobei vom digitalisierten Messkanal-Überlagerungssignal 30 korrekte Messwerte 36 adressiert werden, die zwischen 201 und 207 liegen.

Die zeitliche Folge der adressierten korrekten Messwerte 36 wird als digitales korrektes Messsignal 38 aus der Tabelle 34 ausgelesen beziehungsweise wird von der Tabelle allein aufgrund der zeitlich fortlaufenden Adressierung von sich aus zur Verfügung gestellt. Die ausgegebenen digitalen korrekten Messwerte 36, welche das digitale korrekte Messsignal 38 widerspiegeln, weisen eine Häufigkeitsverteilung 62 des korrekten Messwerts 36 auf, der im gezeigten Ausführungsbeispiel bei 203,6 liegen soll.

In Figur 2 ist eine die einzelnen korrekten Messwerte 36 verbindende Kurve 64 eingetragen, die als interpolierte Kalibrierfunktion interpretiert werden kann. Die Interpolation wird durch eine gegebenenfalls vorgesehene Mittelwertbildung erzielt, die vorzugsweise im Rahmen einer Tiefpassfilterung realisiert wird. Die aus der Tabelle 34 ausgelesen beziehungsweise von der Tabelle 34 bereitgestellten korrekten Messwerte 36 bilden in zeitlicher Folge das digitale korrekte Messsignal 38 mit der Häufigkeitsverteilung 62 der korrekten Messwerte 36, welche von der signalverarbeitenden Anordnung 10 ohne weitere Maßnahmen unmittelbar ausgegeben werden können.

Vorzugsweise ist jedoch das digitale Tiefpassfilter 40 vorgesehen, dessen Grenzfrequenz derart vorgegeben ist, dass eine Mittelwertbildung der Häufigkeitsverteilung 62 der korrekten Messwerte 36 auftritt, jedoch der Frequenzgang des ursprünglichen analogen Messsignals 16 möglichst wenig beeinträchtigt wird. Das vom digitalen Tiefpassfilter 40 bereitgestellte digitale gemittelte korrekte Messsignal 50 kann wieder von der signalverarbeitenden Anordnung 10 unmittelbar ausgegeben werden. Wie bereits erwähnt, wird durch die Mittelwertbildung der in der Tabelle 34 hinterlegten korrekten Messwerte 36 eine Interpolation der korrekten Messwerte 36 erreicht.

Eine Ausgestaltung sieht vor, dass das digitale gemittelte korrekte Messsignal 50 der Schnittstelle 52 zur Verfügung gestellt wird, welche das digitale gemittelte korrekte Messsignal 50 über die externe Signalleitung 56 an einem Ausgang der signalverarbeitende Anordnung 10 bereitstellt.

Die externe Signalleitung 56 kann im Rahmen einer asynchronen seriellen Kommunikation im Duplexbetrieb betrieben werden. Bevorzugt wird die externe Signalleitung 56 gleichzeitig als Stromversorgungsleitung der signalverarbeitenden Anordnung 10 benutzt, die mit der Stromversorgung 58 verbunden ist. In bevorzugter Weise wird die Signalleitung 56 als Eingangsleitung für eine unidirektionale serielle Datenübertragung zur signalverarbeitenden Anordnung 10 genutzt. In diesem Fall kann zur seriellen Datenübertragung von der signalverarbeitenden Anordnung 10 nach außen die analoge Ausgangsleitung 48 im Rahmen einer asynchronen seriellen Datenübertragung herangezogen werden.

Das zu übertragende Signal, entweder bidirektional oder unidirektional, wird der Versorgungsspannung überlagert. Mit einer Kommunikation, bei welcher die analoge Ausgangsleitung 48 und die externe Signalleitung 56 eingesetzt sind, werden keine zusätzlichen weiteren Leitungen benötigt, sodass vorhandene 3-Leitungs-Sensoren eingesetzt werden können.

Die in der Tabelle 34 zu hinterlegenden korrekten Messwerte 36 können über die externe Signalleitung 56 der Schnittstelle 52 in die signalverarbeitende Anordnung 10 eingelesen und über den internen Datenbus 54 in der Tabelle 34 als korrekte Messwerte 36 hinterlegt werden.

Alternativ können die korrekten Messwerte 36 vom Messkanal 12 selbst bereitgestellt werden. Im Rahmen beispielsweise eines Kalibriervorgangs werden die Speicherplätze der Tabelle 34 dadurch adressiert, dass am Messkanal-Sensor 14 die zu erfassenden Messwerte eingestellt werden. In die vom Messkanal-Überlagerungssignal 20 adressierten Speicherplätze werden dann die, beispielsweise über die Signalleitung 56 extern zur Verfügung gestellten korrekten Messwerte 36 in der Tabelle 34 hinterlegt. Bei diesem Vorgang ist das Messkanal-Dithersignal 26 abgeschaltet, sodass das Messkanal-Überlagerungssignal 20 identisch mit dem analogen Messsignal 16 wird.

Die Tabelle 34 kann nicht nur beim Hersteller der signalverarbeitenden Anordnung 10, sondern auch im späteren Einsatz beim Kunden mit aktuellen korrekten Messwerten 36 befüllt werden, um beispielsweise eine Langzeitdrift des Messkanal-Sensors 14 berücksichtigen zu können oder um andere Messbereiche oder um andere Messkanal-Sensoren 14 mit anderen korrekten Messwerten 36 vorsehen zu können.

Zusätzlich oder alternativ kann das digitale korrekte Signal 38 dem Digital/AnalogWandler 42 zugeführt werden, der das analoge korrekte Messsignal 44 bereitstellt, welches vorzugsweise im analogen Tiefpassfilter 46 tiefpassgefiltert wird. Die Tiefpassfilterung entspricht wieder einer Mittelwertbildung, die einerseits dem durch das Messkanal-Dithersignal 26 verursachten Rauschen entgegenwirkt und andererseits das der Häufigkeitsverteilung 62 der korrekten Messwerte 36 zugrundeliegende analoge gemittelte korrekte Messsignal 48 bereitstellt, das im gezeigten Ausführungsbeispiel 203,6 betragen soll, wobei das ursprüngliche analoge Messsignal 16 den Wert 134,3 aufgewiesen hat.

Die analoge Tiefpassfilterung kann mit einem Signalverstärker realisiert werden, der aufgrund der begrenzten Bandbreite der Schaltungsordnung stets ein Tiefpassverhalten aufweist.

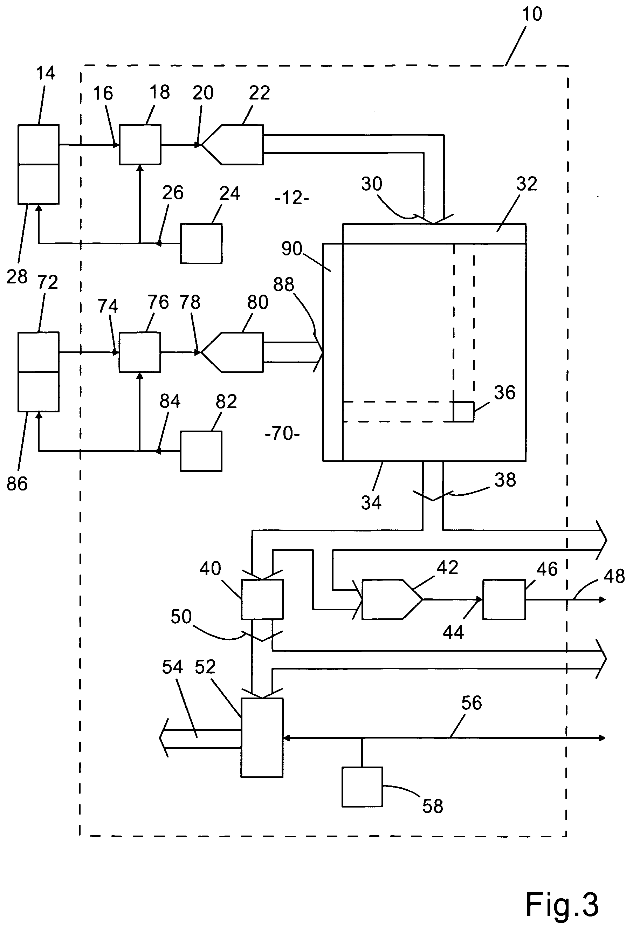

Eine besonders bevorzugte Weiterbildung der erfindungsgemäßen Vorrichtung zur Durchführung des Verfahrens zum digitalen Verarbeiten des analogen Messsignals 16 ist in Figur 3 gezeigt.

Diejenigen in Figur 3 gezeigten Teile, die mit den in Figur 1 gezeigten Teilen übereinstimmen, sind jeweils mit denselben Bezugszeichen bezeichnet.

Gegenüber der in Figur 1 gezeigten Vorrichtung ist die in Figur 3 gezeigte Vorrichtung mit einem Korrekturkanal 70 ergänzt. Mit dem Korrekturkanal 70 ist eine Korrektur einer Querempfindlichkeit des Messkanal-Sensors 14 möglich. Beispielsweise kann der Messkanal-Sensor 14 eine Abhängigkeit von der Temperatur aufweisen, die mittels des Korrekturkanals 70 kompensiert werden kann.

Ein Korrekturkanal-Sensor 72 stellt der signalverarbeitende Anordnung 10 ein analoges Korrektursignal 74 bereit, welches einer Korrekturkanal-Überlagerungsvorrichtung 76 zur Verfügung gestellt wird, die ein Korrekturkanal-Überlagerungssignal 78 an einen Korrekturkanal-Analog/Digital-Wandler 80 weiterleitet.

Ein Korrekturkanal-Dithersignalgenerator 82 stellt ein Korrekturkanal-Dithersignal 84 bereit, welches der Korrekturkanal-Überlagerungsvorrichtung 76 oder einer Korrekturkanal-Sensor-Stromversorgung 86 zugeführt wird.

Der Korrekturkanal-Analog/Digital-Wandler 80 stellt ein digitalisiertes Korrekturkanal-Überlagerungssignal 88 bereit, welches einen zweiten Adressiereingang 90 der Tabelle 34 ansteuert.

Das Korrekturkanal-Dithersignal 84 wie auch das Messkanal-Dithersignal 26 können beispielsweise mittels einer Binär-Zufallszahlenfolge erzeugt werden, welche die vorzugsweise als Mikrocontroller realisierte signalverarbeitende Anordnung 10 an einem nicht näher gezeigten Digitalausgang bereitstellt.

Alternativ können das Messkanal-Dithersignal 26 beziehungsweise das Korrekturkanal-Dithersignal 84 mittels der niedrigwertigsten Bits der Analog/DigitalWandlung des Messkanal-Überlagerungssignals 20 beziehungsweise des Korrekturkanal-Überlagerungssignals 78 bereitgestellt wird. Die höherwertigen Bits des Messkanal-Analog/Digital-Wandlers 22 oder des Korrekturkanal-Analog/DigitalWandlers 80 werden in diesem Fall als Messkanal-Überlagerungssignal 30 beziehungsweise als Korrekturkanal-Überlagerungssignal 88 herangezogen.

Die Funktionsweise des Korrekturkanals 70 stimmt mit der des Messkanals 12 überein. Der Korrekturkanal-Sensor 72 erfasst beispielsweise zumindest ein Maß für die Temperatur des Messkanal-Sensors 14, um die Querempfindlichkeit gegenüber der Temperatur korrigieren zu können. Im Korrekturkanal 70 wird ebenfalls eine vergleichsweise hohe Auflösung des analogen Korrektursignals 74 mit einem vergleichsweise gering auflösenden und daher preiswerten Korrekturkanal-Analog/Digital-Wandler 80 unter Einsatz der Dithersignaltechnik erreicht.

Das digitalisierte Korrekturkanal-Überlagerungssignal 88 wird ebenfalls zur Adressierung der in der Tabelle 34 hinterlegten korrekten Messwerte 36 herangezogen. Während bei dem in Figur 1 gezeigten Ausführungsbeispiel die Tabelle 34 lediglich eine eindimensionale Reihe enthalten braucht, ist bei dem der Figur 3 zugrunde liegenden Ausführungsbeispiel eine zweidimensionale Tabelle 34 vorgesehen.

In weiteren, nicht näher gezeigten Ausgestaltungen können zur Korrektur weiterer Querempfindlichkeiten des Messkanal-Sensors 14 weitere Korrekturkanäle 70 vorgesehen sein, sodass die Tabelle 34 entsprechend mehrdimensional ausgestaltet sein kann.

Der besondere Vorteil der erfindungsgemäßen Vorgehensweise liegt auch bei dem in Figur 3 gezeigten Ausführungsbeispiel darin, dass das digitale korrekte Messsignal 38 ohne Rechenoperationen nur durch Auslesen der in der Tabelle 34 hinterlegten korrekten Messwerte 36 aufgrund der Adressierung sowohl durch das digitalisierte Messkanal-Überlagerungssignal 30 als auch durch das digitalisierte Korrekturkanal-Überlagerungssignal 38 unmittelbar erhalten wird und allein von der Tabelle 34 bereitgestellt werden kann.

Die weitere Verarbeitung des digitalen korrekten Messsignals 38 gemäß dem in Figur 3 gezeigten Ausführungsbeispiel kann wieder entsprechend dem in Figur 1 gezeigten Ausführungsbeispiel erfolgen.

Wie bereits in der Beschreibungseinleitung erwähnt, muss die Tabelle 34 aufgrund der verringerten Auflösung des Messkanal-Analog/Digital-Wandlers 22 und dem entsprechend geringen Adressraum vergleichsweise wenige Speicherplätze zur Verfügung stellen. Wenn wieder von einem 8-Bit Messkanal-Analog/DigitalWandler 22 ausgegangen wird und weiterhin unterstellt wird, dass als Korrekturkanal-Analog/Digital-Wandler 80 ein 4-Bit Analog/Digital-Wandler eingesetzt wird, werden nur 4096 Speicherplätze benötigt. Bei hinterlegten Daten mit einer Breite von 8 bit sind nur 4 kByte erforderlich.

Um eine Auflösung, beispielsweise eines als Messkanal-Sensor 14 eingesetzten induktiven Abstandssensors von 1 % zu erzielen, wird nach dem Stand der Technik ein Messkanal-Analog/Digital-Wandler 22 mit einer Auflösung von mindestens 10 Bit benötigt. Mit der erfindungsgemäßen Vorgehensweise kann eine Auflösung und Nichtlinearität von besser als 0,5 % mit einem 6-Bit Messkanal-Analog/DigitalWandler 22 erreicht werden, sodass bei einem angenommenen Korrekturkanal-Analog/Digital-Wandler 80 mit 4-Bit die Tabelle 34 nur 1024 Speicherplätze bereitstellen muss, die beispielsweise ein Flash-Speicher oder ein EEPROM eines Mikrocontrollers bereitstellen kann. Ausreichend ist hierbei ein 8-Bit Digital/AnalogWandler 42. Die gesamte signalverarbeitende Anordnung 10 einschließlich der Tabelle 34 kann daher mit einem einzigen Mikrocontroller realisiert werden.

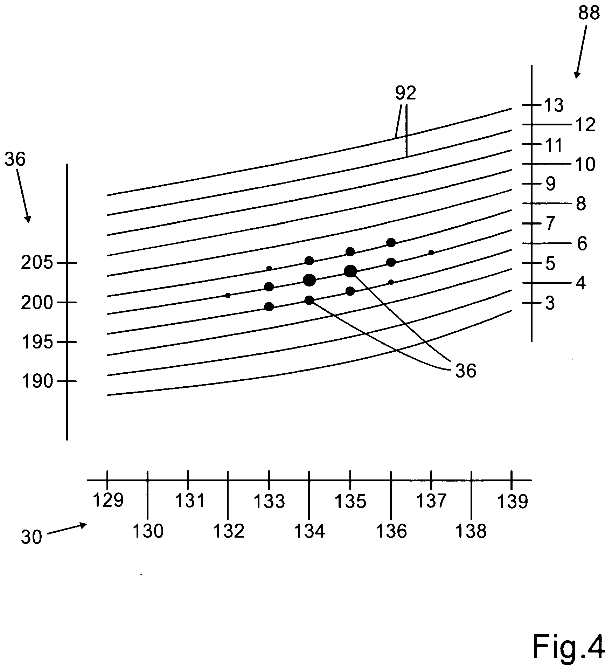

Die Funktionsweise des in Figur 3 gezeigten Ausführungsbeispiels wird anhand des in Figur 4 gezeigten funktionalen Zusammenhang zwischen dem digitalisierten Messkanal-Überlagerungssignal 30, dem digitalisierten Korrekturkanal-Überlagerungssignal 88 und den in der Tabelle 34 hinterlegten korrekten Messwerten 36 näher erläutert:

Die korrekten Messwerte 36 werden nunmehr sowohl mittels des digitalisierten Messkanal-Überlagerungssignals 30 als auch mittels des digitalisierten Korrekturkanal-Überlagerungssignals 88 adressiert.

Das digitalisierte Korrekturkanal-Überlagerungssignal 38 soll beispielsweise zwischen 3 und 13 liegen. Jedem einzelnen Wert des digitalisierten Messkanal-Überlagerungssignals 30 sind mehrere korrekte Messwerte 36 zugeordnet, die in Abhängigkeit von dem digitalisierten Korrekturkanal-Überlagerungssignal 88 adressiert werden. Zur Verdeutlichung der Abhängigkeit der dem digitalisierten Messkanal-Überlagerungssignal 30 entsprechenden korrekten Messwerte 36 von der Temperatur sind in der Figur 4 durchgezogene Linien 92 eingetragen, um eine gegebenenfalls vorhandene Nichtlinearität zu verdeutlichen. In der Tabelle 34 sind jedoch nur die an den Kreuzungspunkten liegenden korrekten Messwerte 36 hinterlegt.

In Figur 4 sind adressierte korrekte Messwerte 36 eingetragen, wobei die unterschiedlichen Durchmesser der Punkte die in Figur 2 gezeigte Häufigkeitsverteilung 62 des korrekten Messwerts 36 widerspiegeln sollen.

Die in der Tabelle 34 zu hinterlegenden korrekten Messwerte 36 können wieder über die externe Signalleitung 56 der Schnittstelle 52 in die signalverarbeitende Anordnung 10 eingelesen und über den internen Datenbus 54 in der Tabelle 34 als korrekte Messwerte 36 hinterlegt werden.

Alternativ können die korrekten Messwerte 36 auch bei diesem Ausführungsbeispiel nicht nur vom Messkanal 12, sondern auch vom Korrekturkanal 70 selbst bereitgestellt werden. Im Rahmen beispielsweise eines Kalibriervorgangs werden die Speicherplätze der Tabelle 34 dadurch adressiert, dass am Messkanal-Sensor 14 und am Korrekturkanal-Sensor 72 die zu erfassenden Messwerte eingestellt werden. In die vom Messkanal-Überlagerungssignal 20 und vom Korrekturkanal-Überlagerungssignal 78 adressierten Speicherplätze werden dann wieder die beispielsweise über die Signalleitung 56 extern zur Verfügung gestellten korrekten Messwerte 36 in der Tabelle 34 hinterlegt. Hierbei sind nicht nur das Messkanal-Dithersignal 26, sondern auch das Korrekturkanal-Dithersignal 84 abzuschalten, sodass das Messkanal-Überlagerungssignal 20 mit dem analogen Messsignal 16 und das Korrekturkanal-Überlagerungssignal 78 identisch mit dem analogen Korrektursignal 74 werden.

Auch bei diesem Ausführungsbeispiel kann das ursprüngliche analoge Messsignal 16 anhand einer digitalen oder analogen Mittelwertbildung weitgehend vom Rauschanteil des Messkanal-Dithersignals 26 und demjenigen des Korrekturkanal-Dithersignals 84 befreit werden.

Die Mittelwertbildung erfolgt wieder vorzugsweise im Rahmen einer bereits beschriebenen Tiefpassfilterung, wobei die Mittelwertbildung wieder zu einer Interpolation führt.

## Patentansprüche

1. Verfahren zur Umwandlung wenigstens eines von wenigstens einem Messkanal-Sensor (14) bereitgestellten analogen Messsignals (16) zu einem analogen gemittelten korrekten Messsignal, wobei dem vom Messkanal-Sensor (14) bereitgestellten analogen Messsignal (16) ein Messkanal-Dithersignal (26) überlagert wird, das entstehende Messkanal-Überlagerungssignal (20) anschließend analog/digital-gewandelt wird, und das digitalisierte Messkanal-Überlagerungssignal (30) unmittelbar eine Tabelle (34) adressiert, wobei in der Tabelle (34) eine Kalibrierfunktion des Messkanal-Sensors (14) als zu den ganzzahligen Werten des digitalisierten analogen Messsignals gehörende korrekte Messwerte (36) hinterlegt ist, das digitalisierte Messkanal-Überlagerungssignal (30) unmittelbar die Tabelle (34) adressiert und die adressierten einzelnen korrekten Messwerte (36) aus der Tabelle (34) ausgelesen und als digitales korrektes Messsignal (38) bereitgestellt werden, **dadurch gekennzeichnet, dass** zur Korrektur einer Querempfindlichkeit gegenüber einer anderen Größe als die Messgröße des vom Messkanal-Sensor (14) bereitgestellten analogen Messsignals (16) weiterhin ein von wenigstens einem Korrekturkanal-Sensor (72), der die andere Größe misst, erfasstes analoges Korrektursignal (74) mit einem Korrekturkanal-Dithersignal (84) überlagert und das entstehende Korrekturkanal-Überlagerungssignal (78) anschließend analog/digital gewandelt wird, dass die Tabelle (34) als wenigstens zweidimensionale Tabelle (34) ausgebildet ist, dass in der Tabelle (34) eine zweidimensionale Kalibrierfunktion hinterlegt ist, dass das digitalisierte Korrekturkanal-Überlagerungssignal (88) die Tabelle (34) ebenfalls unmittelbar adressiert, dass die jeweils vom digitalisierten Messkanal-Überlagerungssignal (30) und dem digitalisierten Korrekturkanal-Überlagerungssignal (88) adressierten, korrekten Messwerte (36) als das digitale korrekte Messsignal (38) aus der Tabelle (34) ausgelesen und als das digitale korrekte Messsignal (38) bereitgestellt werden, das digitale korrekte Messsignal (38) durch einen Digital/Analog-Wandler (42) digital/analog-gewandelt wird, das durch den Digital/AnalogWandler (42) bereitgestellte analoge korrekte Messsignals (44) mittels des analogen Tiefpassfilters (46) gefiltert und als das analoge gemittelte korrekte und gegenüber der Querempfindlichkeit kompensierte Messsignal bereitgestellt wird.

2. Verfahren zur Umwandlung wenigstens eines von wenigstens einem Messkanal-Sensor (14) bereitgestellten analogen Messsignals (16) zu einem digitalen gemittelten korrekten Messsignal, wobei dem vom Messkanal-Sensor (14) bereitgestellten analogen Messsignal (16) ein Messkanal-Dithersignal (26) überlagert wird, das entstehende Messkanal-Überlagerungssignal (20) anschließend analog/digital-gewandelt wird, und das digitalisierte Messkanal-Überlagerungssignal (30) unmittelbar eine Tabelle (34) adressiert, wobei in der Tabelle (34) eine Kalibrierfunktion des Messkanal-Sensors (14) als an den ganzzahligen Werten des digitalisierten analogen Messsignals gehörende korrekte Messwerte (36) hinterlegt ist, das digitalisierten Messkanal-Überlagerungssignal (30) unmittelbar die Tabelle (34) adressiert und die adressierten einzelnen korrekten Messwerte (36) aus der Tabelle (34) ausgelesen und als digitales korrektes Messsignal (38) bereitgestellt werden, das digitale korrekte Messsignal (38) mittels einer digitalen Tiefpassfilterung gefiltert und als digitales gemitteltes korrektes Messsignal bereitgestellt wird, **dadurch gekennzeichnet, dass** zur Korrektur einer Querempfindlichkeit gegenüber einer anderen Größe als die Messgröße des vom Messkanal-Sensor (14) bereitgestellten analogen Messsignals (16) weiterhin ein von wenigstens einem Korrekturkanal-Sensor (72), der die andere Größe misst, erfasstes analoges Korrektursignal (74) mit einem Korrekturkanal-Dithersignal (84) überlagert und das entstehende Korrekturkanal-Überlagerungssignal (78) anschließend analog/digital-gewandelt wird, dass die Tabelle (34) als wenigstens zweidimensionale Tabelle (34) ausgebildet ist, dass in der Tabelle (34) eine zweidimensionale Kalibrierfunktion hinterlegt ist, dass das digitalisierte Korrekturkanal-Überlagerungssignal (88) die Tabelle (34) ebenfalls unmittelbar adressiert und dass die jeweils vom digitalisierten Messkanal-Überlagerungssignal (30) und dem digitalisierten Korrekturkanal-Überlagerungssignal (88) adressierten, korrekten Messwerte (36) als das digitale korrekte Messsignal (38) aus der Tabelle (34) ausgelesen und als das digitale korrekte Messignal (38) bereitgestellt werden, dass das digitale gemittelte korrekte Messsignal als digitale gernittelte korrekte und gegenüber der Querempfindlichkeit kompensierte Messsignal bereitgestellte wird.

3. Verfahren nach Anspruch 1 oder 2, **dadurch gekennzeichnet, dass** das analoge Korrektursignal (74) ein Temperatursignal ist.

4. Verfahren nach Anspruch 1 oder 2, **dadurch gekennzeichnet, dass** das Messkanal-Dithersignal (26) dem analogen Messsignal (16) dadurch überlagert wird, dass eine Messkanal-Sensor-Stromversorgung (28) mit dem Messkanal-Dithersignal (26) moduliert wird.

5. Verfahren nach Anspruch 1 oder 2, **dadurch gekennzeichnet, dass** das Korrekturkanal-Dithersignal (84) dem analogen Korrektursignal (74) dadurch überlagert wird, dass eine Korrekturkanal-Sensor-Stromversorgung (86) mit dem Korrektursignal-Dithersignal (84) moduliert wird.

6. Verfahren nach einem der Ansprüche 1 oder 2, **dadurch gekennzeichnet, dass** das Messkanal-Dithersignal (26) beziehungsweise das Korrekturkanal-Dithersignals (84) mittels einer Binär-Zufallszahlenfolge erzeugt wird.

7. Verfahren nach einem der Ansprüche 1 oder 2, **dadurch gekennzeichnet, dass** das Messkanal-Dithersignal (26) beziehungsweise das Korrekturkanal-Dithersignal (84) mittels der niedrigwertigsten Bits der Analog/DigitalWandlung des Messkanal-Überlagerungssignals (20) beziehungsweise des Korrekturkanal-Überlagerungssignals (78) bereitgestellt wird.

8. Verfahren nach einem der Ansprüche 1 oder 2, **dadurch gekennzeichnet, dass** die Speicherplätze der Tabelle (34) zur Hinterlegung der korrekten Messwerte (36) vom Messkanal (12) beziehungsweise vom Korrekturkanal (70) adressiert werden, wobei am Messkanal-Sensor (14) beziehungsweise am Korrekturkanal-Sensor (72) die zu erfassenden Messwerte eingestellt werden und wobei das Messkanal-Dithersignal (26) beziehungsweise das Korrekturkanal-Dithersignal (84) abgeschaltet werden, und dass in den vom Messkanal-Überlagerungssignal (20) beziehungsweise vom Korrekturkanal-Überlagerungssignal (78) adressierten Speicherplätzen die extern zur Verfügung gestellten korrekten Messwerte (36) hinterlegt werden.

9. Vorrichtung zur Durchführung des Verfahrens nach einem der vorhergehenden Ansprüche, **dadurch gekennzeichnet, dass** eine signalverarbeitende Anordnung (10) vorgesehen ist, die einen Messkanal-Dithersignalgenerator (24), einen Messkanal Analog/Digital-Wandler (22) zur Digitalisierung des Messkanal-Überlagerungssignals (20), dass die signalverarbeitende Anordnung (10) weiterhin einen Korrekturkanal-Dithersignalgenerator (82) und einen Korrekturkanal-Analog/Digital-Wandler (80) zur Digitalisierung des Korrekturkanal-Überlagerungssignals (78) enthält und dass die Tabelle (34) wenigstens als zweidimensionale Tabelle (34) ausgebildet ist, .in welcher die Kalibrierfunktion des Messkanal-Sensors (14) als an den ganzzahligen Werten des digitalisierten analogen Messsignals gehörende korrekte Messwerte (36) hinterlegt sind, einen Digital/Analog-Wandler (42) zur Bereitstellung des analogen korrekten Messsignal (44) sowie ein analoges Tiefpassfilter (46), welches das analoge gemittelte korrekte Messsignal (48) bereitstellt, beziehungsweise ein digitales Tiefpassfilter enthält, welches das digitale gemittelte korrekte Messsignal bereitstellt.

10. Vorrichtung nach Anspruch 9, **dadurch gekennzeichnet, dass** das analoge Tiefpassfilter (46) ein Signalverstärker ist.

11. Vorrichtung nach Anspruch 9, **dadurch gekennzeichnet, dass** die signalverarbeitende Anordnung (10) eine Schnittstelle (52) aufweist.

12. Vorrichtung nach Anspruch 11, **dadurch gekennzeichnet, dass** an der Schnittstelle (52) eine externe Signalleitung (66) angeschlossen ist und dass die signalverarbeitende Anordnung (10) eine analoge Ausgangsleitung (48) bereitstellt.

13. Vorrichtung nach Anspruch 12, **dadurch gekennzeichnet, dass** die Signalleitung (56) eine mit einer Stromversorgung (58) der signalverarbeitende Anordnung (10) verbundene Stromversorgungsleitung ist.

14. Vorrichtung nach Anspruch 9, **dadurch gekennzeichnet, dass** als,Messkanal-Sensor (14) ein induktiver oder kapazitiver Abstandssensor vorgesehen ist.

15. Vorrichtung nach Anspruch 9, **dadurch gekennzeichnet, dass** als Korrekturkanal-Sensor (72) ein Temperatursensor vorgesehen ist.

16. Vorrichtung nach Anspruch 9, **dadurch gekennzeichnet, dass** die signalverarbeitende Anordnung (10) einschließlich der Tabelle (34) mit einem einzigen Mikrocontroller realisiert ist.

## Claims

1. Method for the conversion of at least one analogue measurement signal (16) provided by at least one measurement channel sensor (14) to an analogue, averaged, correct measurement Signal, wherein a measurement channel dither signal (26) is overlaid on the analogue measurement signal (16) provided by the measurement channel sensor (14), the resulting measurement channel overlay signal (20) is then analogue/digitally converted and the digitalised measurement channel overlay signal (30) directly addresses a table (34), wherein a calibration function of the measurement channel sensor (14) is stored in the table (34) as the correct measurement values (36) belonging to the integer values of the digitalised, analogue measurement signal, the digitalised measurement channel overlay signal (30) directly addresses the table (34) and the addressed, individual, correct measurement values (36) are read out from the table (34) and are provided as the digital, correct measurement signal (38),
**characterised in that**, for the correction of a cross-sensitivity compared to a different variable from the measurement variable of the analogue measurement signal (16) provided by the measurement channel sensor (14), an analogue correction signal (74), which is registered by at least one correction channel sensor (72) that measures the other variable, is additionally overlaid with a correction channel dither signal (84) and the resulting correction channel overlay signal (78) is then analogue/digitally converted, the table (34) is formed as an at least two-dimensional table (34), a two-dimensional calibration function is stored in the table (34), the digitalised correction channel overlay signal (88) also directly addresses the table (34), the respective correct measurement values (36) addressed by the digitalised measurement channel overlay signal (30) and the digitalised correction channel overlay signal (88) are read out from the table (34) as the digital, correct measurement signal (38) and are provided as the digital, correct measurement signal (38), the digital, correct measurement signal (38) is digital/analogue converted by a digital/analogue converter (42), the analogue, correct measurement signal (44) provided by the digital/analogue converter (42) is filtered by means of the analogue low pass filter (46) and is provided as the analogue, averaged, correct measurement signal that is compensated for against cross-sensitivity.

2. Method for the conversion of at least one analogue measurement signal (16) provided by at least one measurement channel sensor (14) to a digital, averaged, correct measurement signal, wherein a measurement channel dither signal (26) is overlaid on the measurement signal (16) provided by the measurement channel sensor (14), the resulting measurement channel overlay signal (20) is then analogue/digitally converted, and the digitalised measurement channel overlay signal (30) directly addresses a table (34), wherein a calibration function of the measurement channel sensor (14) is stored in the table (34) as correct measurement values (36) belonging to the integer values of the digitalised, analogue measurement signal, the digitalised measurement channel overlay signal (30) directly addresses the table (34) and the addressed, individual, correct measurement values (36) are read out from the table (34) and are provided as digital, correct measurement signal (38), the digital, correct measurement signal (38) is filtered by means of a digital low pass filter and is provided as the digital, averaged, correct measurement signal, **characterised in that**,
for the correction of a cross-sensitivity compared to a different variable from the measurement variable of the measurement signal (16) provided by the measurement channel sensor (14), an analogue correction signal (74), which is registered by at least one correction channel sensor (72) that measures the other variable, is additionally overlaid with a correction channel dither signal (84) and the resulting correction channel overlay signal (78) is then analogue/digitally converted, the table (34) is formed as an at least two-dimensional table (34), a two-dimensional calibration function is stored in the table (34), the digitalised correction channel overlay signal (88) also directly addresses the table (34), and the respective correct measurement values (36) addressed by the digitalised measurement channel overlay signal (30) and the digitalised correction channel overlay signal (88) are read out from the table (34) as the digital, correct measurement signal (38) and are provided as the digital, correct measurement signal (38), the digital, averaged, correct measurement signal is provided as digital, averaged, correct measurement signal that is compensated for against cross-sensitivity.

3. Method according to claim 1 or 2, **characterised in that** the analogue correction signal (74) is a temperature signal.

4. Method according to claim 1 or 2, **characterised in that** the measurement channel dither signal (26) is overlaid on the analogue measurement signal (16) in such way, that a measurement channel sensor power supply (28) is modulated with the measurement channel dither signal (26).

5. Method according to claim 1 or 2, **characterised in that** the correction channel dither signal (84) is overlaid on the analogue correction signal (74) in such way, that a correction channel sensor power supply (86) is modulated with the correction signal dither signal (84).

6. Method according to one of claims 1 or 2, **characterised in that** the measurement channel dither signal (26) or the correction channel dither signal (84) is generated by means of a binary random number sequence.

7. Method according to one of claims 1 or 2, **characterised in that** the measurement channel dither signal (26) or the correction channel dither signal (84) is provided by means of the lowest-value bits of the analogue/digital conversion of the measurement channel overlay signal (20) or the correction channel overlay signal (78).

8. Method according to one of claims 1 or 2, **characterised in that** the storage spaces of the table (34) for storing the correct measurement values (36) is addressed by the measurement channel (12) or by the correction channel (70), wherein the measurement values to be registered are adjusted at the measurement channel sensor (14) or at the correction channel sensor (72), and wherein the measurement channel dither signal (26) or the correction channel dither signal (84) is switched off, and the correct measurement values (36) provided externally are stored in the storage spaces addressed by the measurement channel overlay signal (20) or by the correction channel overlay signal (78).

9. Device for carrying out the method according to one of the preceding claims, **characterised in that** a signal-processing arrangement (10) is provided which contains a measurement channel dither signal generator (24), a measurement channel analogue/digital converter (22) for digitalising the measurement channel overlay signal (20), the signal-processing arrangement (to) furthermore contains a correction channel dither signal generator (82) and a correction channel analogue/digital converter (80) for digitalising the correction channel overlay signal (78), and the table (34) is formed as at least a two-dimensional table (34) in which the calibration function of the measurement channel sensor (14) is stored as correct measurement values (36) belonging to the integer values of the digitalised, measurement signal, provides a digital/analogue converter (42) for the provision of the analogue, correct measurement signal (44), as well as an low pass filter (46) which provides the analogue, averaged, correct measurement signal (48), or contains a digital low pass filter which provides the digital, averaged, correct measurement signal.

10. Device according to claim 9, **characterised in that** the analogue low pass filter (46) is a signal amplifier.

11. Device according to claim 9, **characterised in that** the signal-processing arrangement (10) has an interface (52).

12. Device according to claim 11, **characterised in that** an external signal line (56) is connected to the interface (52) and the signal-processing arrangement (10) provides an output line (48).

13. Device according to claim 12, **characterised in that** the signal line (56) is a power supply line that is connected to a power supply (58) of the signal-processing arrangement (10).

14. Device according to claim 9, **characterised in that** an inductive or capacitive distance sensor is provided as the measurement channel sensor (14).

15. Device according to claim 9, **characterised in that** a temperature sensor is provided as the correction channel sensor (72).

16. Device according to claim 9, **characterised in that** the signal-processing arrangement (10), including the table (34), is implemented with a single micro controller.

## Revendications

1. Procédé permettant de convertir au moins un signal de mesure analogique (16) fourni par au moins un capteur de canal de mesure (14) en un signal de mesure analogique moyenné exact selon lequel, au signal de mesure analogique (16) fourni par le capteur de canal de mesure (14) on superpose un signal de tremblement du canal de mesure (26), le signal de battement du canal de mesure (20) obtenu est ensuite soumis à une conversion analogique / numérique et le signal de battement du canal de mesure numérisé (30) adresse directement une table (34), dans cette table (34) est déposée une fonction de calibrage du capteur de canal de mesure (14) sous la forme de valeurs de mesure exactes (36) faisant partie des valeurs entières du signal de mesure analogique numérisé, le signal de battement du canal de mesure numérisé (30) adresse directement la table (34) et les différentes valeurs de mesure exactes (36) adressées sont lues dans la table (34) et fournies en tant que signal de mesure numérique exact (38),
**caractérisé en ce que**
pour effectuer la correction de la sensibilité transversale vis-à-vis d'une grandeur autre que la grandeur de mesure du signal de mesure analogique (16) fournie par le capteur de canal de mesure (14), on superpose en outre, à un signal de correction analogique (74) détecté par au moins un capteur de canal de correction (72) qui mesure l'autre grandeur, un signal de tremblement du canal de correction (84) et le signal de blattement du canal de correction (78) obtenu est ensuite soumis à une conversion analogique / numérique, la table (34) est réalisée sous la forme d'au moins une table bidimentionnelle (34), dans la table (34) est déposée une fonction de calibrage bidimentionnelle, le signal de battement du canal de correction (88) numérisé adresse également directement la table (34), les valeurs de mesure exactes (36) respectivement adressées par le signal de battement du canal de mesure numérisé (30) et le signal de battement du canal de correction numérisé (88) sont lues dans la table (34) en tant que le signal de mesure numérique exact (38), et sont fournies en tant que le signal de mesure numérique exact (38), le signal de mesure numérique exact (38) est soumis à une conversion numérique / analogique par un convertisseur numérique / analogique (42), le signal de mesure analogique exact (44) fourni par le convertisseur numérique / analogique (42) est filtré au moyen d'un filtre passe-bas analogique (46) et est fourni en tant que le signal de mesure analogique moyenné exact et compensé vis-à-vis de la sensibilité transversale.

2. Procédé permettant de convertir au moins un signal de mesure analogique (16) fourni par au moins un capteur de canal de mesure (14) en un signal de mesure numérique moyenné exact selon lequel, au signal de mesure analogique (16) fourni par le capteur de canal de mesure (14) on superpose du signal de tremblement du canal de mesure (26), le signal de battement du canal de mesure (20) obtenu est ensuite soumis à une conversion analogique / numérique, et le signal de battement du canal de mesure numérisé (30) adresse directement une table (34), dans cette table (34) est déposée une fonction de calibrage du capteur de canal de mesure (14) sous la forme de valeurs de mesure exactes (36) faisant partie des valeurs entières du signal de mesure analogique numérisé, le signal de battement du canal de mesure numérisé (30) adresse directement la table (34) et les différentes valeurs de mesure exactes adressées (36) sont lues dans la table (34) et fournies en tant que signal de mesure numérique exact (38), le signal de mesure numérique exact (38) est filtre au moyen d'un filtre passe bas numérique et fourni en tant que signal de mesure numérique moyenné exact, **caractérisé en ce que**
pour effectuer la correction, de la sensibilité transversale vis-à-vis d'une grandeur autre que la grandeur de mesure du signal de mesure analogique (16) fournie par le capteur de canal de mesure (14), on superpose en outre, à un signal de correction analogique (74) détecté par au moins un capteur de canal de correction (72) qui mesure l'autre grandeur, un signal de tremblement du canal de correction (84), et le signal de battement du canal de correction obtenu (78) est ensuite soumis à une conversion analogique / numérique, la table (34) est réalisée sous la forme d'au moins une table bidimensionnel (34), dans la table (34) est déposée une fonction de calibrage bidirectionnelle, le signal de battement du canal de correction numérisé (88) adresse également directement la table (34) et les valeurs de mesure exactes (36) adressées respectivement par le signal de battement du canal de mesure numérisé (30) et du signal de battement (88) du canal de correction numérisé sont lues dans la table (34) en tant que le signal de mesure numérique exact (38), et sont fournies en tant que le signal de mesure numérique exact (38), et le signal de mesure numérique moyenné exact est fourni en tant que signal de mesure numérique moyenné exact et compensé vis-à-vis de la sensibilité transversale.

3. Procédé conforme à la revendication 1 ou 2,
**caractérisé en ce que**
le signal de correction analogique (74) est un signal de température.

4. Procédé conforme à la revendications 1 ou 2,
**caractérisé en ce que**
le signal de tremblement du canal de mesure (26) est superposé au signal de mesure analogique (16) de sorte que l'alimentation en courant (28) du capteur de canal de mesure soit modulée par le signal de tremblement du canal de mesure (26).

5. Procédé conforme à la revendication 1 ou 2,
**caractérisé en ce que**
le signal de tremblement du canal de correction (84) est superposé au signal de correction analogique (74) de sorte que l'alimentation en courant (86) du capteur de canal de correction soit modulée par le signal de tremblement (84) du signal de correction.

6. Procédé conforme à l'une des revendications 1 et 2,
**caractérisé en ce que**
le signal de tremblement du canal de mesure (26) ou le signal de tremblement (84) du canal de correction est produit au moyen d'une suite de nombres binaires aléatoire.

7. Procédé conforme à l'une des revendications 1 et 2,
**caractérisé en ce que**
le signal de tremblement du canal de mesure (26) ou le signal de tremblement (84) du canal de correction est fourni au moyen des bits d'ordre inférieur de la conversion analogique / numérique du signal de battement (20) du canal de mesure ou du signal de battement (78) du canal de correction.

8. Procédé conforme à l'une des revendications 1 et 2,
**caractérisé en ce que**
les emplacements de mémoire de la table (34) sont adressées pour permettre de déposer les valeurs de mesure exactes (36) du canal de mesure (12) ou du canal de correction (70), selon lequel, sur le capteur de canal de mesure (14) ou le capteur de canal de correction (72), les valeurs de mesure à détecter sont réglées, le signal de tremblement du canal de mesure (26) ou le signal de tremblement (84) du canal de correction est coupé, et, les valeurs de mesure exactes (36) préparées en externe sont déposées dans les emplacements de mémoire adressés par le signal de battement du canal de mesure (20) ou le signal de battement du canal de correction (78).

9. Dispositif permettant la mise en oeuvre du procédé conforme à l'une des revendications précédentes,
**caractérisé en ce qu'**
il comporte un dispositif de traitement de signal (10) qui comprend un générateur de signal de tremblement (24) de canal de mesure, un convertisseur analogique / numérique (22) de canal de mesure pour permettre de numériser le signal de battement du canal de mesure (20), en outre une générateur de signal de tremblement (82) de canal de correction et un convertisseur analogique / numérique de canal de correction (80) permettant de numériser le signal de battement (78) du canal de correction, et la table (34) est réalisée au moins sous la forme d'une table bidimensionnelle (34) dans laquelle la fonction de calibrage du capteur de canal de mesure (14) est déposées sous la forme de valeurs de mesure exactes (36) faisant partie des valeurs entières du signal de mesure analogique numérisé, un convertisseur numérique / analogique (42) pour fournir le signal de mesure analogique exact (44) ainsi qu'un filtre passe-bas analogique (46) qui fournit le signal de mesure analogique moyenné exact (48) ou un filtre passe-bas numérique qui fournit le signal de mesure numérique moyenné exact.

10. Dispositif conforme à la revendication 9,
**caractérisé en ce que**
le filtre passe-bas analogique (46) est un amplificateur de signal.

11. Dispositif conforme à la revendication 9,
**caractérisé en ce que**
le dispositif de traitement de signal (10) comprend une interface (52).

12. Dispositif conforme à la revendication 11,
**caractérisé en ce qu'**
une conduite d'acheminement de signal externe (56) est branchée sur l'interface (52) et le dispositif de traitement de signal (10) fournit une conduite de sortie analogique (48).

13. Dispositif conforme à la revendication 12,
**caractérisé en ce que**
la conduite d'acheminement de signal (56) est une conduite d'alimentation en courant reliée à alimentation en courant (58) du dispositif de traitement de signal (10).

14. Dispositif conforme à la revendication 9,
**caractérisé en ce que**
en tant que capteur de canal de mesure (14) il est prévu un capteur de distance inductif ou capacitif.

15. Dispositif conforme à la revendication 9,
**caractérisé en ce que**
en tant que capteur de canal de correction (72) il est prévu un capteur de temperature.

16. Dispositif conforme à la revendication 9,
**caractérisé en ce que**
le dispositif de traitement de signal (10), y compris la table (34) est réalisé avec un seul micro-contrôleur.
